# EUROPÄISCHE PATENTSCHRIFT

(11) **EP 1 181 747 B1**
(45) Veröffentlichungstag und Bekanntmachung des Hinweises auf die Patenterteilung: **02.01.2004**
(21) Anmeldenummer: 99971973.5
(22) Anmeldetag: 22.10.1999
(51) Int. Cl.: H01R 13/514, H01R 13/20, H01R 13/66

(54) **BAUSTEINSYSTEM ZUM AUFBAU ELEKTRISCHER UND ELEKTRONISCHER SCHALTUNGEN**
MODULAR SYSTEM FOR ESTABLISHING ELECTRIC AND ELECTRONIC CIRCUITS
SYSTEME MODULAIRE POUR MONTER DES CIRCUITS ELECTRIQUES ET ELECTRONIQUES

(30) Priorität: 06.11.1998 DE 19851197
(43) Veröffentlichungstag der Anmeldung: 27.02.2002
(73) Patentinhaber: PALIMONDIAL S.A., L-1371 Luxembourg (LU)
(72) Erfinder: Larws, Peter, 7304 Maienfeld (CH)
(74) Vertreter: Aue, Hans-Peter
(86) Internationale Anmeldenummer: PCT/EP1999/008035
(87) Internationale Veröffentlichungsnummer: WO 2000/028626

(56) Entgegenhaltungen:
- WO-A-93/17767
- WO-A-97/12349
- GB-A- 2 270 850
- US-A- 3 447 249
- US-A- 3 576 936
- US-A- 4 242 778

## Beschreibung

Die Erfindung betrifft ein Bausteinsystem zum Aufbau elektrischer und elektronischer Schaltungen, bestehend aus einer Mehrzahl zusammenzusteckender Bausteine aus jeweils einem formgleichen Oberteil und Unterteil aus einem nichtelektrisch leitendem Material, in die mindestens ein elektrisches oder elektronisches Bauelement einklemmbar ist.

Für den Bau von statischen Objekten gibt es Bausteine, die ohne jede Verbindungsmöglichkeit lediglich aufeinandergesetzt oder nebeneinandergereiht werden. Den mit diesen Bausteinen errichteten Objekten fehlt jedoch jeglicher Zusammenhalt, so daß diese bei Erschütterungen zusammenfallen können.

Bausteine sind in den verschiedensten Ausführungsformen bekannt. Derartige Bausteine mit unterschiedlicher geometrischer Gestalt werden häufig durch vielgestaltige Verbindungselemente miteinander verbunden und zu Baueinheiten montiert. Darüber hinaus sind auch Spielbausteine bekannt, die in der Regel in einer großen Anzahl zu Spielbausteinsystemen bzw. Spielbausteinkästen zusammengestellt werden, damit ein Benutzer die Spielbausteine zu beliebigen Gebilden und Formen kombinieren kann. Die Bausteine bestehen in der Regel aus Kunststoff oder häufig auch aus Metall, Holz, Stein oder dergleichen. Insbesondere dann, wenn die Bausteine aus Kunststoff bestehen, sind diese in eine nahezu beliebige Formen bringbar.

Aus der DE-AS-14 78 380 ist ein rechteckiger Spielbaustein mit quadratischem Querschnitt bekannt, der an allen Seitenflächen je eine in Längsrichtung verlaufende und an einer Stirnfläche hinterschnittene Verbindungsnut aufweist und an der anderen Stirnfläche mit einem hinterschnittenen leistenähnlichen Verbindungszapfen versehen ist. Die hinterschnittenen Nuten sind als rohrförmig ausgeweitete Schlitze ausgebildet, in die der Verbindungszapfen eines anderen Spielbausteins formschlüssig eingefügt werden kann. Hierbei muß der Verbindungszapfen des einen Spielbausteins mit hohem Kraftaufwand in die Verbindungsnut des anderen Spielbausteins eingedrückt werden, da die Hinterschneidungskanten an der Verbindungsnut leicht aufgeweitet werden müssen, da der Abstand zwischen den hinterschnittenen Kanten der Verbindungsnut geringer ist als die Breite des Verbindungszapfens. Dabei wird, insbesondere bei Kunststoff-Bausteinen, der Verbindungszapfen oder die Hinterschneidungskanten der Verbindungsnut zusammengepreßt und verformt. Dadurch ist ein mehrmaliger Gebrauch der Verbindungselemente begrenzt. Wird der Abstand der sich gegenüberliegenden Hinterscheidungskanten der Verbindungsnut vergrößert, so wird die Verbindung insgesamt instabil.

Des weiteren sind Steckbausteine bekannt, welche mittels rückseitiger Steckkontakte auf speziell verdrahteten Steckplattenmontiert werden und somit elektrisen miteinander verbunden sind. Bei anderen Bausteinen werden die elektrischen Kontakte durch Permanentmagnete zusammengehalten oder die Kontakte durch Kunststoff-Klemmverbindungen festgespannt.

Alle diese bekannten Ausführungen von Bausteinen sind relativ aufwendig herzustellen oder bieten keine sichere Verbindung der Kontaktelemente.

Ferner offenbart die US-PS 3,576,936 einen quadratischen Spielbaustein, der durch einen Deckel verschlossen wird. An den Stirnseiten des Bausteins befinden sich Verbindungsnuten, von denen eine zwei Schlitze aufweist. Unterhalb des Deckels ist eine elektronische Komponente, beispielsweise ein Kondensator angeordnet, dessen Anschlusskontakte derart in den Randbereich des Deckels ragen, dass diese beim Aufsetzen des Deckels auf den Baustein in die Schlitze der einen Verbindungsnut an einer dessen Stirnseiten eingreifen.

Es ist Aufgabe der Erfindung, ein Bausteinsystem der eingangs genannten Art zu schaffen, das kostengünstig herstellbar ist und eine sichere Kontaktierung der Bausteine untereinander ermöglicht.

Erfindungsgemäß wird die Aufgabe dadurch gelöst, dass an den Berührungsflächen der zusammensteckbaren Bausteine Kontaktelemente aus einem elektrisch leitenden Material angeordnet sind, um ein Oberteil und ein Unterteil unter Klemmung eines Bauelementes zu einem Baustein zu verbinden, wobei weiterhin derartige Bausteine über diese Kontaktelemente miteinander verbindbar sind, und die Kontaktelemente einerseits als federnder Eingangskontakt und andererseits als federnder Ausgangskontakt ausgebildet sind, zwischen denen die Anschlüsse des Bauelementes festklemmbar ist.

Durch die erfindungsgemäße Ausbildung des. Bausteinsystems können einerseits jeweils das formgleiche Oberteil und das formgleiche Unterteil eines Bausteins durch die Kontaktelemente fest miteinander verbunden und andererseits gleichzeitig benachbarte Bausteine zusammengesteckt werden. Darüber hinaus werden auch gleichzeitig die den zu verbindenden Bausteinen zugeordneten elektrischen oder elektronischen Bauelemente sicher miteinander verbunden. Dadurch kann auf getrennte Verbindungselemente und separate Kontaktelemente verzichtet werden. Insbesondere, wenn die zu verbindenden Bausteine des Bausteinsystems aus Kunststoff bestehen und die Kontaktelemente jeweils einstückig ausgebildet sind, kann die Herstellung des Bausteinsystems kostengünstig erfolgen. Des weiteren wird eine einfache industrielle Montage der zu verbindenden Bausteine ermöglicht. Schließlich besteht auch die Möglichkeit, daß der Endabnehmer die Bausteine mit elektrischen oder elektronischen Bauelementen selbst nach eigener Auswahl bestückt. Durch die federnden Eingangs- und Ausgangskontakte werden universelle Kombinationsmöglichkeiten bei der Bestückung zu verbindender Bausteine zu elektrischen oder elektronischen Schaltungen ermöglicht. Somit erfolgt eine gleichartige Befestigung der Bausteine des Bausteinsystems untereinander durch die federnden Eingangs- und Ausgangskontakte.

Beim Zusammenstecken des Oberteils und des Unterteils eines Bausteins werden gleichzeitig auch die Anschlüsse des elektrischen oder elektronischen Bauelementes verklemmt, wobei die Kontaktelemente auch gleichzeitig zum Zusammenstecken zweier benachbarter Bausteine genutzt werden.

Zur Arretierung des Eingangskontaktes bzw. Ausgangskontaktes am jeweils zugehörigen Baustein ist jedes Kontaktelement in dazu korrespondierende Halterungen im Oberteil und Unterteil einsetzbar ist. Diese Halterungen können vorzugsweise einstückig mit dem Oberteil bzw. Unterteil des Bausteins ausgebildet sein, was insbesondere bei Bausteinen aus Kunststoff leicht realisierbar ist. Durch das kraftund formschlüssige Verbinden der Kontaktelemente erfolgt eine sichere elektrische Verbindung zwischen den Bausteinen durch Zusammenstecken der Eingangs- und Ausgangskontakte.

Vorzugsweise sind die Eingangs- und Ausgangskontakte unterschiedlich geformt. Dabei sind diese jedoch derart zueinander korrespondierend ausgebildet, daß ein Ausgangskontakt des einen Bausteins mit einem Eingangskontakt eines anderen Bausteins und umgekehrt zusammengefügt werden kann.

Nach einer bevorzugten Ausbildung der Kontaktelemente sind die Eingangs- und Ausgangskontakte klammerartig ausgebildet. So kann beispielsweise ein klammerförmiger Eingangskontakt des einen Bausteins einen dazu korrespondierenden Ausgangskontakt des anderen zu verbindenden Bausteins klammerartig umgreifen.

In Fortbildung des Erfindungsgedankens besteht das Oberteil und/oder Unterteil jedes zusammensteckbaren Bausteins aus einem transparenten Material. Diese Ausbildung der Bausteine ist insbesondere dann von Vorteil, wenn die in die Bausteine eingesetzten elektrischen oder elektronischen Bauelemente für Lehrzwecke anschaulisch gezeigt werden sollen, den das transparente Unterteil und/oder Oberteil ermöglichen einen Blick in das Innere des Bausteins.

Eine andere Verdeutlichung der Anordnung und Funktion des elektrischen oder elektronischen Bauelementes im Baustein besteht darin, daß die Oberfläche des Oberteils und/oder Unterteils jedes Bausteins mit einer graphischen Darstellung eines Schaltplanes oder Teil eines solchen versehen ist. Somit kann durch erfindungsgemäßes Aneinanderfügen von Bausteinen eine Schaltungsanordnung auf deren Oberfläche dargestellt werden. Dies ist insbesondere zu Lehr- und Unterrichtszwecken von Vorteil. Dem entsprechend kann z.B. auf der Oberfläche des Oberteils des Bausteins ein Schaltsymbol, beispielsweise ein Widerstand oder eine Diode, durch Aufdrucken oder mittels Aufkleber aufgebracht werden.

Zur Vervielfältigung der Kombinationsmöglichkeiten der Bausteine eines Bausteinsystems und der Anordnung der zugehörigen elektrischen oder elektronischen Bauelemente ist es vorteilhaft, wenn die zu verbindenden Bausteine zueinander korrespondierende Rastermaße aufweisen und zu einer Schaltungsanordnung bzw. einem Schaltplan zusammensetzbar sind. Sonach können beispielsweise Bausteine mit quadratischem Querschnitt an ihren vier Seitenflächen jeweils ein Kontaktelement aufweisen. Sollen z.B. an zwei sich gegenüberliegenden Seiten der Bausteine jeweils mehr als ein Kontakt vorgesehen werden, sind die Rastermaße der Ober- und Unterteile der Bausteine entsprechend zu vergrößern.

Zu Lehr- und Unterrichtszwecken kann es hilfreich sein, wenn das Unterteil jedes Bausteins mit einem Permanentmagneten versehen ist. Dadurch können mehrere Bausteine zur Verdeutlichung eines Schaltplanes an einer Magnetwand befestigt werden.

Schließlich sind erfindungsgemäß die daß die Bausteine als beliebig geformte geometrische Elemente, insbesondere Spielfiguren ausgebildet sind, die vor allem für Kinder und Jugendliche eine Lehrfunktion ausüben.

An Hand von Ausführungsbeispielen wir der der Erfindung zugrunde liegende Gedanke in der nachfolgenden Beschreibung näher erläutert. In den zugehörigen zeichnungen zeigt:
- Fig. 1: einen Baustein eines erfindungsgemäßen Bausteinsystems, bestehend aus Oberteil und Unterteil mit montagebereiten Kontaktelementen,
- Fig. 2: einen Baustein nach Fig. 1 mit im Unterteil eingesetzten Kontaktelementen,
- Fig. 3: ein Unterteil eines Bausteins nach den Fig. 1 und 2 mit einem eingeklemmten elektrischen Bauelement,
- Fig. 4: zwei kraft- und formschlüssig miteinander verbundenen Kontaktelemente,
- Fig. 5: mehrere Bausteine des erfindungsgemäßen Bausteinsystems vor deren Montage,
- Fig. 6: eine Mehrzahl von Bausteinen nach Fig. 5 im zusammengesteckten Zustand und
- Fig. 7: eine andere Ausführungsform eines Bausteines nach dem erfindungsgemäßen Bausteinsystem.

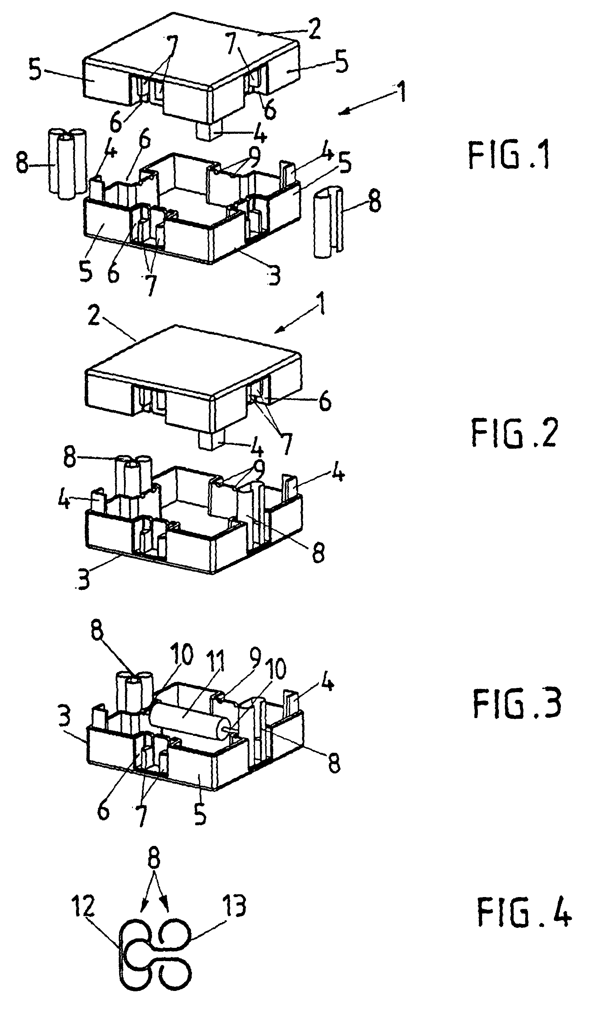

Ein Bausteinsystem zum Verbinden mehrerer Bausteine 1 ist in den Fig. 1 bis 6 dargestellt. Die zu verbindenden Bausteine 1 sind quaderförmig und mit rechteckigem Querschnitt ausgebildet. Sie bestehen aus einem nicht elektrisch leitendem Material, vorzugsweise aus Kunststoff. Die Abmessungen der Bausteine 1 orientieren sich an einem bestimmten vorgegebenen Rastermaß.

Ein Baustein 1 besteht aus einem Oberteil 2 und einem Unterteil 3, die an sich jeweils diagonal gegenüberliegenden Ecken mit Führungselementen 4 versehen sind. Diese Führungselemente 4 dienen als Hilfe und Arretierung beim Zusammenstecken des Oberteils 2 und des Unterteils 3. Gegebenenfalls kann auf diese Führungselemente 4 verzichtet werden.

An jeder Seitenfläche 5 befindet sich eine Aussparung 6, in der paarweise Halterungen 7 angeformt sind. Auf die Halterungen 7 werden Kontaktelemente 8 aufgesteckt, so daß diese vom Oberteil 2 in das Unterteil 2 oder umgekehrt ragen. An den Aussparungen 6 im Oberteil 2 und im Unterteil 3 sind Aufnahmen 9 für drahtartige Anschlüsse 10 eines elektrischen oder elektronischen Bauelementes 11, beispielsweise einen Widerstand, wie in Fig. 3 gezeigt, vorgesehen.

Ein solches elektrisches oder elektronische Bauelement 11 wird mit seinen Anschlüssen 10 in die entsprechenden Aufnahmen 9 des Unterteils 3 gemäß Fig. 3 eingelegt. Danach werden die Kontaktelemente 8 an den beiden sich gegenüberliegenden Seitenflächen 5 des Unterteils 3 in die Aussparungen 6 eingesetzt, so daß die Kontaktelemente 8 durch die Halterungen 7 in den Aussparungen 6 festgeklemmt werden. Gleichzeitig werden beim Einsetzen der Kontaktelemente 8 die drahtartigen Anschlüsse 10 des elektrischen oder elektronischen Bauelementes 11 in der Aussparung 6 des Unterteils 3 festgeklemmt. Nun erfolgt das Aufsetzen des Oberteils 2 auf das Unterteil 3 derart, daß die Kontaktelemente 8 in die entsprechenden Halterungen 7 der Aussparungen 6 im Oberteil 2 des Bausteins 1 eingreifen. Dadurch sind das Oberteil 2 und das Unterteil 3 des Bausteins 1 form- und kraftschlüssig miteinander verbunden.

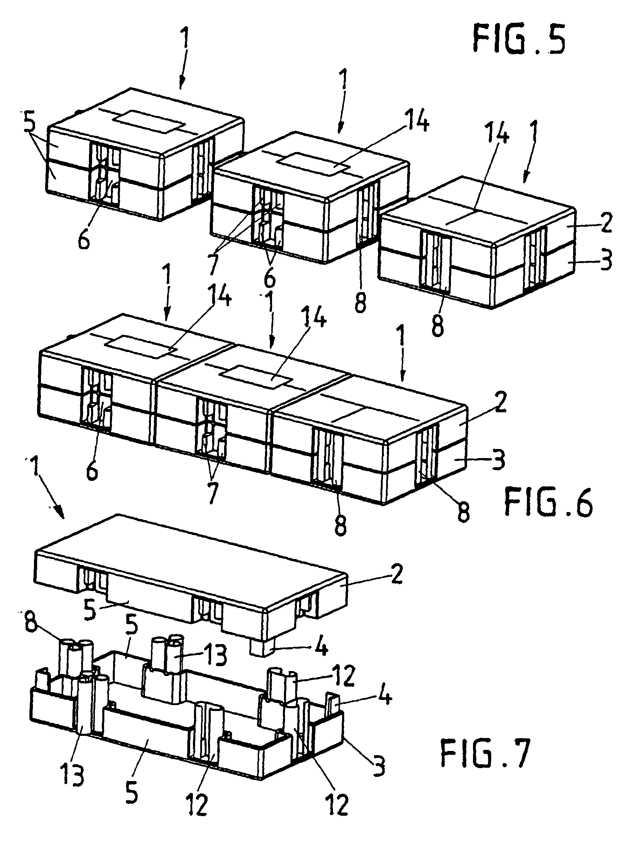

Fig. 4 zeigt zwei zueinander korrespondierende Kontaktelemente 8, wobei das linke Kontaktelement 8 als Eingangskontakt 12 und das rechte Kontaktelement 8 als Ausgangskontakt 13 ausgebildet sind. Diese bestehen aus einem metallischen, elektrisch leitenden Material, vorzugsweise Federstahl. Beim Zusammenstecken zweier benachbarter Bausteine 1 gemäß den Fig. 5 und 6 greift der Ausgangskontakt 13 des einen Bausteins 1 in den Eingangskontakt 12 des benachbarten Bausteins 1 ein, so daß der Eingangskontakt 12 den Ausgangskontakt 13 klammerartig umschließt. Somit erfolgt eine stabile und kontaktsichere Verbindung zweier benachbarter Bausteine 1.

Gemäß den Fig. 5 und 6 ist auf der Oberfläche jedes Bausteins 1 jeweils ein Schaltsymbol 14 graphisch dargestellt. Dadurch kann der Benutzer sofort erkennen, welches elektrische oder elektronische Bauelement 11 dem jeweiligen Baustein 1 zugeordnet ist. Durch die Kombination mehrerer zusammengesteckter Bausteine 1 kann ein beliebiger Schaltplan oder Teils eines Schaltplanes realisiert werden.

Fig. 7 zeigt einen anderen Baustein 1, der quaderförmig mit rechteckigem Querschnitt ausgebildet ist. Sonach sind an seinen beiden länglichen Seitenflächen 5 jeweils zwei Kontaktelemente 8 angeordnet, wodurch beispielsweise mehrere Bausteine 1 nach den Fig. 1 bis 5 an diesem Baustein 1 in zusammensteckender Weise befestigt werden können, wie dies zuvor beschrieben wurde.

### Liste der Bezugszeichen

- 1: Baustein
- 2: Oberteil
- 3: Unterteil
- 4: Führungselement
- 5: Seitenfläche
- 6: Aussparung
- 7: Halterung
- 8: Kontaktelement
- 9: Aufnahme
- 10: Anschluß
- 11: Bauelement
- 12: Eingangskontakt
- 13: Ausgangskontakt
- 14: Schaltsymbol

## Patentansprüche

1. Bausteinsystem zum Aufbau elektrischer und elektronischer Schaltungen, bestehend aus einer Mehrzahl zusammenzusteckender Bausteine (1) aus jeweils einem formgleichen Oberteil (2) und Unterteil (3) aus einem nichtelektrisch leitendem Material, in die mindestens ein elektrisches oder elektronisches Bauelement (11) einklemmbar ist, **dadurch gekennzeichnet, dass** an den Berührungsflächen (5) der zusammensteckbaren Bausteine (1) Kontaktelemente (8) aus einem elektrisch leitenden Material angeordnet sind, um ein Oberteil (2) und ein Unterteil (3) unter Klemmung eines Bauelementes (11) zu einem Baustein (1) zu verbinden, wobei weiterhin derartige Bausteine (1) über diese Kontaktelemente (8) miteinander verbindbar sind, und diese Kontaktelemente (8) einerseits als federnder Eingangskontakt (12) und andererseits als federnder Ausgangskontakt (13) ausgebildet sind, zwischen denen die Anschlüsse (10) des Bauelementes (11) festklemmbar ist.

2. Bausteinsystem nach Anspruch 1, **dadurch gekennzeichnet, dass** jedes Kontaktelement (8) in dazu korrespondierende Halterungen (7) im Oberteil (2) und Unterteil (3) einsetzbar ist.

3. Bausteinsystem nach Anspruch 1 oder 2, **dadurch gekennzeichnet, dass** die Eingangs- und Ausgangskontakte (12,13) unterschiedlich geformt sind.

4. Bausteinsystem nach einem der Ansprüche 1 bis 3, **dadurch gekennzeichnet, dass** die Eingangs- und Ausgangskontakte (12,13) klammerartig ausgebildet sind.

5. Bausteinsystem nach einem der Ansprüche 1 bis 4, **dadurch gekennzeichnet, dass** das Oberteil (2) und/oder Unterteil.(3) jedes zusammensteckbaren Bausteins (1) aus einem transparenten Material besteht.

6. Bausteinsystem nach einem der Ansprüche 1 bis 5, **dadurch gekennzeichnet, dass** die Oberfläche des Oberteils (2) und/oder Unterteils (3) jedes Bausteins (1) mit einer grafischen Darstellung (14) eines Schaltplanes oder Teil eines solchen versehen ist.

7. Bausteinsystem nach einem der Ansprüche 1 bis 6, **dadurch gekennzeichnet, dass** an jeder mit einem anderen Baustein (1) verbindbaren Seite eines Bausteins (1) mindestens ein Kontaktelement (8) angeordnet ist, wobei an einer Seite des einen Bausteins (1) ein Eingangskontakt (12) und an der zu verbindenden Seite des anderen Bausteins (1) ein Ausgangskontakt (13) einsetzbar sind.

8. Bausteinsystem nach einem der Ansprüche 1 bis 7, **dadurch gekennzeichnet, dass** die zu verbindenden Bausteine (1) zueinander korrespondierende Rastermaße aufweisen und zu einer Schaltungsanordnung bzw. einem Schaltplan zusammensetzbar sind.

9. Bausteinsystem nach einem der Ansprüche 1 bis 8, **dadurch gekennzeichnet, dass** das Unterteil (3) jedes Bausteins (1) mit einem Permanentmagneten versehen ist .

10. Bausteinsystem nach einem der Ansprüche 1 bis 9, **dadurch gekennzeichnet, dass** die Bausteine (1) als beliebig geformte geometrische Elemente, insbesondere Spielfiguren ausgebildet sind.

## Claims

1. Modular system for making electrical and electronic circuits, consisting of a number of modules which have to be plugged together (1) consisting of one upper part respectively, shaped in the same way (2) and a lower part (3) consisting of a non-electrically conductive material, where at least one electrical or electronic construction element (11) can be pressed together, **characterized in** this way, by the fact that contact elements (8) consisting of a non-electrically conductive material are fitted at the contact surfaces (5) of the modules which can be plugged together (1) , in order to connect one top part (2) and one lower part (3) by pressing together one component (11) with a module (1) , so that these types of modules (1) can still be connected to each other by using these contact elements (8) and so that the contact elements (8) can be formed, on one hand, as an elastic input contact (12) and, on the other hand as an elastic output contact (13), between which the connections (10) of the component (11) can be firmly pressed in.

2. Modular system according to claim 1, **characterized in** this way, by the fact that each contact element (8) can be inserted into the corresponding holders (8) in the upper part (2) and the lower part (3).

3. Modular system according to claim 1 or 2, **characterized in** this way, the input and output contacts (12,13),are shaped in different ways.

4. Modular system according to one of the claims 1 to 3, **characterized in** this way, by the fact that the input and output contacts (12,13) are shaped in the form of clamps.

5. Modular system according to one of the claims 1 to 4, **characterized in** this way, by the fact that the upper part (2) and/or the lower part (3) of each module that can be plugged together (1) is/are made out of a transparent material.

6. Modular system according to one of the claims 1 to 5, **characterized in** this way, by the fact that the surface of the top part (2) and/or the lower part (3) of each component (1) is provided with a graphical representation (4) of a wiring diagramme or part of a plan of this type.

7. Modular system according to one of the claims 1 to 6, **characterized in** this way, by the fact that at least one contact element (8) is fitted at each of the edges of the module (1) which comes into contact with another module (1) so that an input contact (12) can be positioned at one side of a particular module (1) and an output contact (13) can be positioned at the connecting side of the other module (1) .

8. Modular system according to one of the claims 1 to 7, **characterized in** this way, by the fact that the modules to be connected (1) have modular dimensions corresponding to each other and which can be combined into a wiring layout or a wiring plan.

9. Modular system according to one of the claims 1 to 8, **characterized in** this way, by the fact that the lower part (3) of each module (1) is provided with a permanent magnet.

10. Modular system according to one of the claims 1 to 9, **characterized in** this way, by the fact that the modules (1) are shaped as formed geometric elements, especially as game figures.

## Revendications

1. Système modulaire pour la réalisation de circuits électriques et électroniques composés de plusieurs modules appariés (1) constitués chacun d'une partie supérieure (2) et d'une partie inférieure (3) de forme identique fabriquées à partir d'un matériau non conducteur et dans laquelle au moins un élément de construction électrique ou électronique (11) peut être inséré, **caractérisé en ce que** les surfaces de contact (5) des modules appariables (1) sont pourvues d'éléments de contact (8) à partir d'un matériau conducteur pour assembler la partie supérieure (2) et la partie inférieure (3) en un module (1) par jonction d'un élément de construction (11). Assembler d'autres modules (1) similaires à travers ces éléments de contact (8) restant toujours possible et les éléments de contact (8) revêtent respectivement la forme de contacts élastiques d'entrée (12) et de sortie (13) de part et d'autre, entre lesquels les raccordements (10) de l'élément de construction (11) peuvent être fixés.

2. Système modulaire conforme à la revendication 1, **caractérisé en ce que** chaque élément de contact (8) est propre à s'encastrer dans les supports (7) correspondants de la partie supérieure (2) et de la partie inférieure (3) .

3. Système modulaire conforme à la revendication 1 ou 2, **caractérisé en ce que** les contacts d'entrée et de sortie (12,13) sont de conception différente.

4. Système modulaire conforme à l'une quelconque des revendications 1 à 3, **caractérisé en ce que** les contacts d'entrée et de sortie (12,13) sont conçus sous forme de crochets.

5. Système modulaire conforme à l'une quelconque des revendications 1 à 4, **caractérisé en ce que** la partie supérieure (2) et/ou la partie inférieure (3) de chaque module appariable (1) est issue d'un matériau transparent.

6. Système modulaire conforme à l'une quelconque des revendications 1 à 5, **caractérisé en ce que** la surface de la partie supérieure (2) et/ou de la partie inférieure (3) de chaque module (1) comporte une représentation graphique (14) de tout ou partie d'un schéma de circuit.

7. Système modulaire conforme à l'une quelconque des revendications 1 à 6, **caractérisé en ce que** sur chaque face de contact d'un module (1) avec un autre module (1) se trouve au moins un élément de contact (8), un contact d'entrée (12) et un contact de sortie (13) pouvant être installés, respectivement, sur une face d'un module (1) et sur la surface de contact de l'autre module (1).

8. Système modulaire conforme à l'une quelconque des revendications 1 à 7, **caractérisé en ce que** les modules (1) à accoupler présentent des dimensions modulaires compatibles entre elles et sont propres à constituer des circuits ou un schéma de circuit.

9. Système modulaire conforme à l'une quelconque des revendications 1 à 8, **caractérisé en ce que** la partie inférieure (3) de chaque module (1) est équipée d'un aimant permanent.

10. Système modulaire conforme à l'une quelconque des revendications 1 à 9, **caractérisé en ce que** les modules (1) sont formés d'éléments à géométrie quelconque, de pions en particulier.
